(19) Europäisches Patentamt
European Patent Office
Office européen des brevets

(11) **EP 3 283 891 B1**

(12) **FASCICULE DE BREVET EUROPEEN**

(45) Date de publication et mention de la délivrance du brevet:
**13.03.2024 Bulletin 2024/11**

(21) Numéro de dépôt: **16721874.2**

(22) Date de dépôt: **07.04.2016**

(51) Classification Internationale des Brevets (IPC):
**G01R 27/06** (2006.01)     **G01R 31/26** (2020.01)
**G01R 31/265** (2006.01)     **G01R 31/311** (2006.01)
**G01R 31/28** (2006.01)     **H01L 21/66** (2006.01)

(52) Classification Coopérative des Brevets (CPC):
**G01R 31/2656; G01R 27/06; G01R 31/2648; G01R 31/2831; G01R 31/311; H01L 22/14**

(86) Numéro de dépôt international:
**PCT/FR2016/050800**

(87) Numéro de publication internationale:
**WO 2016/166449 (20.10.2016 Gazette 2016/42)**

(54) **MESURE SANS CONTACT DE LA CONDUCTIVITÉ DE SEMI-CONDUCTEURS**

KONTAKTLOSE MESSUNG DER LEITFÄHIGKEIT VON HALBLEITERN

CONTACTLESS MEASUREMENT OF THE CONDUCTIVITY OF SEMICONDUCTORS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **16.04.2015 FR 1553392**

(43) Date de publication de la demande:
**21.02.2018 Bulletin 2018/08**

(73) Titulaires:
• **CNRS**
  **Centre National de la Recherche Scientifique**
  **75016 Paris (FR)**
• **Université Paris-Saclay**
  **91190 Gif-sur-Yvette (FR)**
• **École Supérieure d'Électricité**
  **91192 Gif sur Yvette Cedex (FR)**

(72) Inventeurs:
• **MENCARAGLIA, Denis**
  **91440 Bures Sur Yvette (FR)**
• **LE BIHAN, Yann**
  **94230 Cachan (FR)**
• **LOETE, Florent**
  **91300 Massy (FR)**

(74) Mandataire: **Hautier IP**
  **20, rue de la Liberté**
  **06000 Nice (FR)**

(56) Documents cités:
**US-A- 4 286 215      US-A- 4 303 885
US-A1- 2004 100 280      US-A1- 2004 138 838
US-B1- 6 369 603**

**EP 3 283 891 B1**

**Description**

La présente invention est relative à la mesure sans contact de la conductivité de semi-conducteurs.

On connaît déjà usuellement des procédés de caractérisation sans contact de la conductivité de semi-conducteurs, utilisant un signal électrique monofréquentiel.

Par exemple, le document US 4286215 divulgue un tel procédé de mesure sans contact de la conductivité par courant de Foucault. Ce type de procédé de mesure du genre en question est analogue à un oscillateur utilisant un signal électrique mono-fréquence. Ce type de procédé de mesure nécessite d'effectuer une mesure de référence de la conductivité à l'obscurité pour ensuite estimer le déséquilibre sous éclairement modulé. Le maximum de sensibilité concernant la mesure de la conductivité, pour des dopages et des épaisseurs usuelles de plaquettes de silicium, se situe aux alentours de 13 MHz. Un système utilisant un signal mono-fréquentiel n'est donc adapté qu'à la caractérisation d'un seul type de matériaux, dans une gamme d'épaisseur et de conductivité restreintes. Le document US4303885 enseigne un autre procédé de détection de la conductivité d'un objet à tester par application de courants de Foucault.

La présente invention vise notamment à pallier ces inconvénients.

A cet effet, l'invention concerne un procédé de mesure sans contact de la conductivité de semi-conducteurs tel que défini par la revendication 1.

Un tel procédé de mesure permet notamment de caractériser la conductivité de nombreux types de matériaux en effectuant des mesures sur une large gamme de fréquences.

Un tel procédé permet ainsi la caractérisation d'une large gamme de semi-conducteurs de conductivités différentes et d'épaisseurs différentes, et éventuellement de semi-conducteurs multicouches.

En outre, un tel procédé permet de mesurer la conductivité de matériaux au cours de leur traitement, ce qui est notamment avantageux pour effectuer des contrôles qualités systématiques et par une méthode rapide dans des chaînes de production.

Dans divers modes de réalisation du procédé selon l'invention, on peut éventuellement avoir recours en outre à l'une et/ou à l'autre des dispositions suivantes:

- le signal émis multi-fréquentiel est de la forme :

$$\mathrm{x(t)} = \sum_{i=1}^{N/2} a_i \cos\left(\frac{2\pi i}{NT_e}t + \varphi_i\right)$$

avec i qui représente l'indice de la ième fréquence, $T_e$ la période d'émission des échantillons, $a_i$ l'amplitude des N/2 fréquences et $\varphi_i$ leurs phases respectives.
- le système d'analyse du troisième ensemble utilise un modèle reliant la variation d'impédance du deuxième ensemble à la conductivité de la cible, l'étape e) du procédé comprenant préalablement les étapes suivantes réalisées par le troisième ensemble :

  e1) à partir de la valeur du coefficient de réflexion ou de transmission, déterminer la variation d'impédance du deuxième ensemble sur la gamme de fréquences,
  e2) avec le modèle, en déduire la conductivité de la cible à partir de la variation d'impédance du deuxième ensemble ;

- le système d'analyse du troisième ensemble utilise un modèle de l'interaction électromagnétique entre l'élément inducteur et la cible semi-conductrice et un algorithme de minimisation, l'étape e) du procédé étant effectuée par méthode itérative selon les étapes suivantes :

  e'1) à partir de la valeur du coefficient de réflexion ou de transmission, déterminer la variation d'impédance du deuxième ensemble sur la gamme de fréquences,
  e'2) fournir une valeur d'entrée initiale de conductivité théorique de la cible dans le modèle,
  e'3) évaluer à partir du modèle la variation d'impédance du deuxième ensemble théorique pour la gamme de fréquences,
  e'4) évaluer la différence entre la variation d'impédance du deuxième ensemble théorique et la variation d'impédance du deuxième ensemble mesurée,
  e'5) minimiser ladite différence ;

- le procédé est adapté pour déterminer plusieurs conductivités simultanément d'une cible semi-conductrice multicouche ou pour la mesure de plusieurs cibles semi-conductrices ;
- le procédé est adapté pour déterminer l'épaisseur de chacune des couches de la cible semi-conductrice multicouche ;
- le premier ensemble comprend au moins un convertisseur numérique analogique, ledit convertisseur étant adapté pour émettre un signal multi-fréquentiel, le premier ensemble comprenant également un système d'acquisition convertisseur analogique numérique, ledit système d'acquisition étant adapté pour recevoir un signal multi-fréquentiel réfléchi ou transmis ;
- le premier ensemble comprend au moins un système de couplage, ledit système de couplage étant adapté pour coupler le signal émis par le convertisseur numérique analogique dans la ligne de transmission, et coupler le signal réfléchi ou transmis vers le système d'acquisition convertisseur analogique numérique ;
- le premier ensemble comprend au moins deux systèmes de couplage, un premier système de couplage étant adapté pour coupler le signal émis par le convertisseur numérique analogique dans une première ligne de transmission, et un deuxième système de couplage étant adapté pour coupler le signal réfléchi ou transmis dans une deuxième ligne de transmission vers le système d'acquisition convertisseur analogique numérique ;
- la gamme de fréquence du signal émis est comprise entre 100kHz et 300MHz ;
- la gamme de fréquence est choisie de sorte que les variations du coefficient de réflexion ou de transmission sont maximales pour une variation donnée de conductivité autour d'une fréquence de mesure particulière ; et
- le procédé utilise une gamme de fréquence élevée pour mesurer des conductivités faibles.

L'invention concerne également un dispositif de mesure sans contact de la conductivité de semi-conducteur tel que défini par la revendication 11.

Dans divers modes de réalisation du dispositif selon l'invention, on peut éventuellement avoir recours en outre à l'une et/ou à l'autre des dispositions suivantes:

- l'élément inducteur est imprimé sur un circuit, ledit circuit étant positionné à proximité de la cible semi-conductrice ; et
- l'élément inducteur est une bobine comprenant un rayon intérieur et un rayon extérieur, et dans lequel la cible s'étend dans un plan perpendiculaire à une direction principale de l'élément inducteur suivant deux dimensions, les rayons intérieur et extérieur de l'élément inducteur étant inférieurs aux dimensions de la cible, voire de l'ordre de la moitié des dimensions de la cible.

D'autres caractéristiques et avantages de l'invention apparaîtront au cours de la description suivante d'une de ses formes de réalisation, donnée à titre d'exemple non limitatif, en regard des dessins joints :

- la figure 1 représente schématiquement un premier mode de réalisation d'un dispositif de mesure de conductivité selon l'invention comprenant un premier ensemble, un deuxième ensemble et un troisième ensemble connecté au premier ensemble ;
- la figure 2 représente schématiquement un autre mode de réalisation du dispositif de mesure de conductivité selon l'invention comprenant un premier ensemble, un deuxième ensemble et un troisième ensemble connecté au premier ensemble ;
- la figure 3 représente schématiquement un autre mode de réalisation du dispositif de mesure de conductivité selon l'invention comprenant également un ensemble de référence connecté au premier ensemble ;
- la figure 4 représente une vue schématique en perspective du deuxième ensemble des figures 1 et 2 ;
- la figures 4A représente une vue schématique de côté du deuxième ensemble de la figure 4 ;
- la figure 4B représente une vue schématique en coupe selon le plan IVB-IVB de la figure 4A ;
- la figure 5 représente la partie réelle et la partie imaginaire de la variation d'impédance de l'élément inducteur en fonction de l'épaisseur de la cible ;
- la figure 6 représente la partie réelle et la partie imaginaire de la variation d'impédance de de l'élément inducteur en fonction de la conductivité de la cible ;
- la figure 7 représente la partie réelle du coefficient de réflexion en fonction de la fréquence du signal émis et de la conductivité de la cible ; et
- la figure 8 représente la partie imaginaire du coefficient de réflexion en fonction de la fréquence du signal émis et de la conductivité de la cible.

Sur les différentes figures, les mêmes références désignent des éléments identiques ou similaires.

La conductivité d'une cible de matériau semi-conducteur 4 (appelé par la suite « cible ») est mesurée par la transmission d'un signal multi-fréquentiel dans un élément inducteur 3 de taille et de forme variables, par exemple une bobine 3, placée à proximité de la cible 4. La bobine 3 est par exemple réalisée sur un circuit imprimé inséré dans un circuit électronique. L'élément inducteur 3 a une hauteur h3 et s'étend entre une extrémité avant 3a et une extrémité arrière 3b. Par avant et arrière, on désigne ici respectivement l'extrémité de l'élément inducteur 3 la plus proche de la cible 4 et l'extrémité la plus éloignée de la cible 4. En variante, plusieurs éléments inducteurs 3, notamment des bobines 3, peuvent être utilisées, chaque élément inducteur 3 étant adapté pour une gamme de fréquence $\Delta f$.

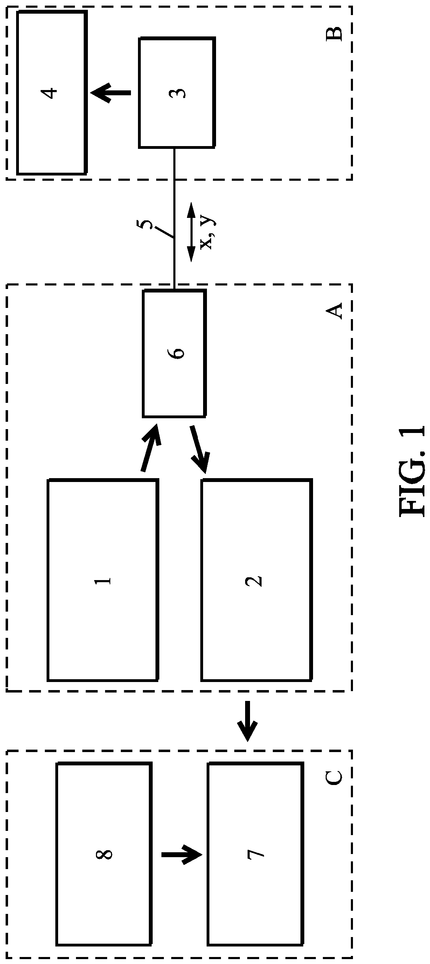

Comme illustré sur la figure 1, le dispositif de mesure de conductivité comprend un premier ensemble A d'émission-réception d'un signal multifréquences. Le dispositif de mesure comprend également un deuxième ensemble B comprenant la cible 4 et un élément inducteur 3 placé à proximité de la cible 4. Le premier ensemble A et deuxième ensemble B sont reliés entre eux par une ligne de transmission 5.

Le premier ensemble A émet un signal X multi-fréquentiel vers le deuxième ensemble B le long de la ligne de transmission 5, et mesure le signal réfléchi ou transmis Y par le deuxième ensemble B vers le premier ensemble A le long de la ligne de transmission 5. Dans la suite, on désignera également le signal réfléchi ou transmis Y comme étant le signal reçu Y par le premier ensemble A.

Un troisième ensemble C est connecté au premier ensemble A. Les signaux émis X et reçu Y sont analysés par le troisième ensemble C. Le troisième ensemble C détermine le coefficient de réflexion $\rho$ ou de transmission R (appelé par la suite « rapport Y/X ») du signal réfléchi ou transmis Y par rapport au signal émis X par le deuxième ensemble B. La conductivité de la cible 4 est ainsi déduite.

Plus particulièrement comme illustré sur la figure 1, le premier ensemble A comprend un système de génération de signal 1, notamment basé sur un convertisseur numérique analogique (appelé par la suite « DAC »). Le premier ensemble A comprend également un système d'acquisition 2, notamment basé sur un convertisseur analogique numérique (appelé par la suite « ADC »). Le premier ensemble A comprend également un système de couplage 6 adapté pour coupler le signal émis X par le DAC 1 dans la ligne de transmission 5 et coupler le signal reçu Y vers l'ADC 2.

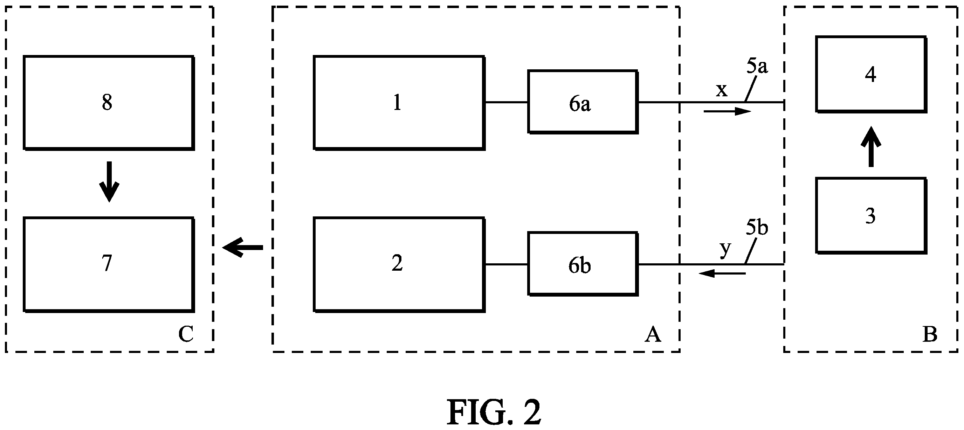

En variante, comme illustré sur la figure 2, le premier ensemble A peut comprendre un premier système de couplage 6a et un deuxième système de couplage 6b. Le premier système de couplage 6a est adapté pour coupler le signal émis X par le DAC 1 vers la ligne de transmission 5. Le deuxième système de couplage 6b est adapté pour coupler le signal transmis Y depuis la ligne de transmission vers l'ADC 2. Selon cette réalisation, une première ligne de transmission 5a transmet le signal émis X depuis le premier ensemble A à l'élément inducteur 3 tandis qu'un deuxième fil de transmission 5b transmet le signal reçu Y depuis le deuxième ensemble B, notamment depuis l'élément inducteur 3, au premier ensemble A.

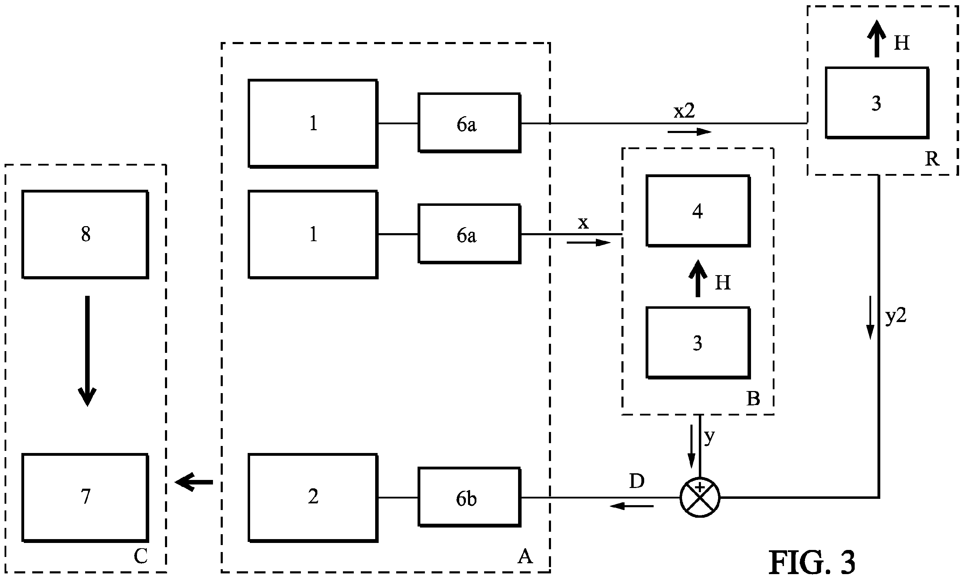

Selon une autre variante, comme illustré sur la figure 3, le premier ensemble peut également être connecté à un ensemble de référence R. plus précisément, le premier ensemble A comprend également un DAC 1a additionnel et un premier système de couplage 6a additionnel. Ainsi, le premier ensemble A est également adapté pour émettre un signal X2 vers l'ensemble de référence R. Dans un autre mode de réalisation, un seul DAC 1 peut être utilisé pour émettre les signaux X et X2. Le signal X2 correspond au signal émis X vers le deuxième ensemble B déphasé d'une phase P.

L'ensemble de référence R comprend un élément inducteur 3 identique à celui de deuxième ensemble B, notamment comme cela sera décrit ci-après. Toutefois, à la différence du deuxième ensemble B, l'ensemble de référence R ne comprend pas de cible 4. L'ensemble de référence R permet ainsi de mesurer le signal transmis ou réfléchi Y2 par l'élément inducteur 3 lorsque cet élément inducteur 3 se trouve en l'absence de la cible 4, c'est-à-dire lorsque l'élément inducteur 3 est uniquement entourée d'air à proximité. En variante, l'élément inducteur 3 de l'ensemble de référence R peut se trouver entouré d'un matériau de référence ou se trouver à proximité d'une cible de référence.

Un bloc permet par la suite d'additionner, et notamment d'amplifier, le signal émis ou réfléchi Y par le deuxième ensemble B avec le signal émis ou réfléchi Y2 par l'ensemble de référence R. On obtient ainsi un signal final D tel que :

$$ D = A * (Y + Y2) $$

Avec A une constante d'amplification. En particulier, P est de préférence égal à $\pi$ afin de réaliser une amplification différentielle entre les signaux Y et Y2. Le signal final D est ensuite transmis au premier ensemble A, et notamment vers ADC 2.

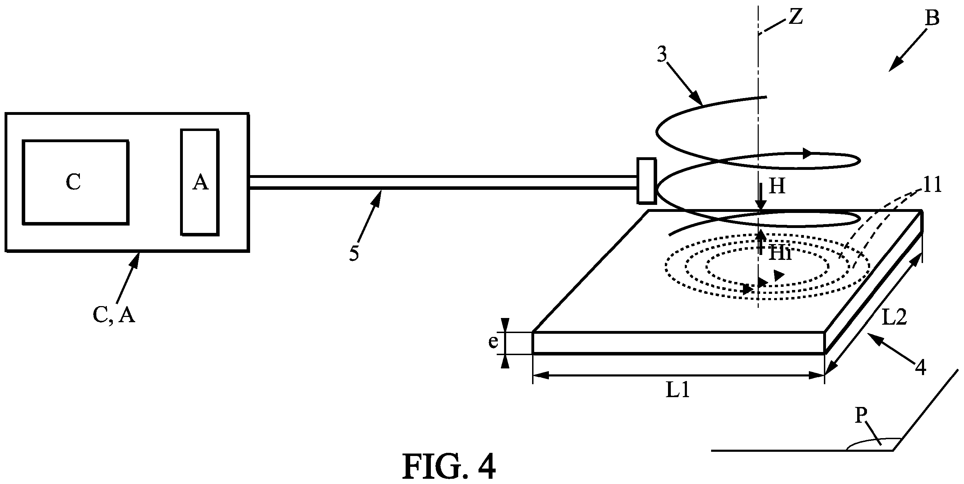

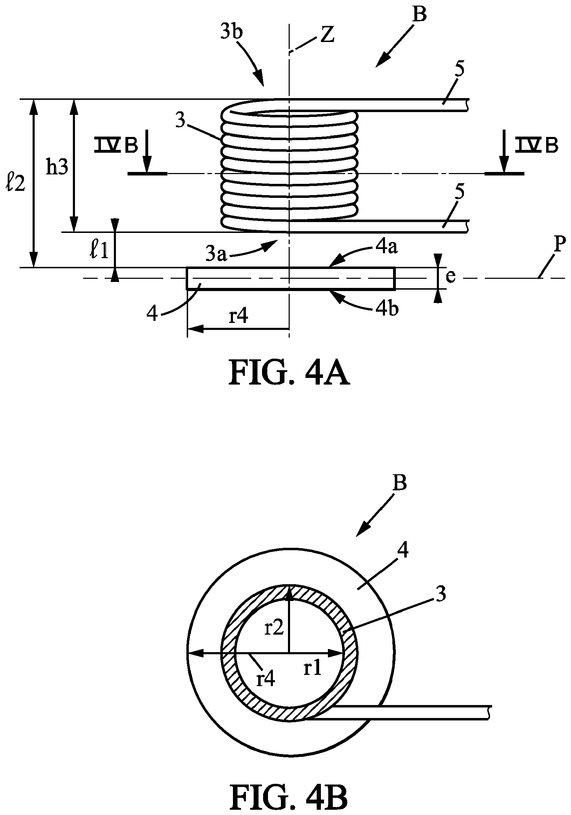

Dans le deuxième ensemble B, la cible de semi-conducteur 4 est située à proximité de l'élément inducteur 3. En particulier, la cible 4 s'étend dans un plan P perpendiculaire à une direction principale Z de l'élément inducteur 3 comme illustré par la figure 4.

Comme représenté plus en détails sur les figures 4A et 4B, la cible 4 peut être circulaire. Selon cette réalisation, la cible 4 a un rayon r4. La cible 4 comprend ainsi une épaisseur e selon la direction principale Z entre une première face 4a et une deuxième face 4b. La première face 4a est notamment à une distance 11 de l'extrémité avant 3a de l'élément inducteur 3 suivant la direction principale Z. La première face 4a est également à une distance 12 de l'extrémité arrière 3b de l'élément inducteur 3 suivant la direction principale Z. Autrement dit, les distances 11, 12 et la hauteur h3 de l'élément inducteur 3 sont liées par la relation :

```
h3 = l2-l1.
```

Comme représenté plus en détails sur la figure 4B, l'élément inducteur 3 peut être une bobine et comprend un rayon intérieur r1 et un rayon extérieur r2. Les rayons intérieur et extérieur r1, r2 sont par exemple respectivement égaux au rayon r4 de la cible 4. En variante, les rayons intérieur et extérieur r1, r2 sont respectivement inférieurs au rayon r4 de la cible 4. De préférence, les distances l1, l2 entre les faces 4a, 4b de la cible 4 et la bobine 3 sont petites devant les rayons intérieur et extérieur r1, r2 de la bobine 3.

A titre d'exemple, pour une gamme de fréquences Δf comprise entre 1MHz et 50MHz, une bobine 3 ayant un rayon extérieur r2 de 3cm avec 5 spires peut être utilisée afin de mesurer la conductivité d'une cible 4 ayant un rayon r4 dans le plan P égale à environ 3 cm. Le nombre de spires de la bobine 3 peut notamment être réduit lors de l'utilisation de fréquences plus élevées.

Selon une autre réalisation représenté sur la figure 4, la cible 4 peut être carrée ou rectangulaire et s'étend dans le plan P selon deux dimensions L1, L2. Les dimensions L1, L2 de la cible 4 sont de préférence respectivement égales à environ 10cm dans le plan P. Selon cet autre exemple, les dimensions L1, L2 sont de préférence égales à environ quatre fois le rayon extérieur r2 de la bobine 3.

De cette façon, la cible 4, et notamment le champ magnétique induit Hi (comme expliqué ci-après), interagit avec l'élément inducteur 3. La distance l1 entre la cible 4 et l'élément inducteur 3 est alors par exemple de l'ordre de 1mm.

La ligne de transmission 5 relie le premier ensemble A au deuxième ensemble B. La ligne de transmission 5 a une impédance caractéristique $Z_{ligne}$ adaptée à l'impédance de sortie de l'ensemble A. La ligne de transmission 5 est par exemple une piste sur un circuit imprimé ou un câble coaxial ou un fil ou une ligne bifilaire.

Le troisième ensemble C comprend un système d'analyse des données 7, le troisième ensemble C étant apte à analyser les données du signal émis X et du signal réfléchi ou transmis Y par le deuxième ensemble B. Le troisième ensemble C permet ainsi de déduire le rapport Y/X du signal reçu Y par le deuxième ensemble B par rapport au signal émis X, puis la conductivité de la cible 4.

Le fonctionnement du dispositif va maintenant être décrit plus en détails.

Un signal multi-fréquentiel X est émis sur une gamme de fréquence Δf par le DAC 1 du premier ensemble A. Le signal est par exemple de la forme :

$$x(t) = \sum_{i=1}^{n} A_i \cos(\omega_i t + \varphi_i)$$

qui est la somme de signaux de N fréquences $w_i$ différentes, avec $A_i$ l'amplitude de ces N signaux, et $\varphi_i$ la phase de chacun des signaux. Pour chaque fréquence $w_i$, l'amplitude A peut notamment être supérieure ou égale à zéro.

Plus précisément, le signal émis X peut être de la forme :

$$x(t) = \sum_{i=1}^{N/2} a_i \cos\left(\frac{2\pi i}{NT_e} t + \varphi_i\right)$$

avec i qui représente l'indice de la ième fréquence, $T_e$ la période d'émission des échantillons, $a_i$ l'amplitude de N/2 fréquences et $\varphi_i$ leurs phases respectives. Les N/2 fréquences sont plus précisément choisies sur une gamme de fréquence Δf pertinente pour la caractérisation de la cible 4. Les amplitudes $a_i$ peuvent être supérieures ou égales à zéro et différentes afin de pondérer le signal émis X en fonction du souhait de l'utilisateur, notamment en atténuant ou annulant certaines fréquences. Les phases $\varphi_i$ peuvent être choisies arbitrairement mais idéalement de manière à minimiser le facteur de crête c :

$$c = \frac{|x|_{peak}}{x_{RMS}}$$

Un tel signal émis X contient simultanément toutes les fréquences utiles à la caractérisation du deuxième ensemble B. En particulier, la durée minimale du signal émis X est fixée par sa fréquence fondamentale $f_1$, plus précisément déterminée par $f_1 = \frac{1}{NT_e}$. Par exemple, si $f_1$ = 1MHz, la période $T_e$ du signal émis X est de 1μs.

Il est alors possible de réaliser une mesure de la conductivité de la cible 4 sur un temps très court et d'observer des variations très rapides de la conductivité.

Les périodes du signal émis X peuvent être générées de manière continue ou par salve au cours du temps. Les périodes du signal reçu Y correspondant peuvent ainsi éventuellement être moyennées. Ceci permet également de caractériser l'évolution de la cible 4 au cours de temps, par exemple par analyse fréquentielle du type transformation de Fourier rapide (FFT) à fenêtre glissante.

En variante, le signal émis X peut être un signal dont la fréquence varie de manière séquentielle, par exemple avec une période de temps à une première fréquence $f_{T1}$ puis une période de temps à une deuxième fréquence $f_{T2}$, ou avec une fréquence fixe au cours du temps.

Le dispositif de mesure permet donc de mesurer la conductivité de la cible 4 dans différents régimes, que ce soit en régime continu ou en régime dépendant du temps.

Le signal émis X est couplé par l'intermédiaire du système de couplage 6, notamment du premier système de couplage 6a, à la ligne de transmission 5 afin d'être transmis à la ligne de transmission 5, notamment à la première ligne de transmission 5a. Le signal émis X est ainsi reçu par le deuxième ensemble B. Plus précisément, l'élément inducteur 3 du deuxième ensemble B est alimenté par le signal émis X.

Comme illustré à la figure 4, l'élément inducteur 3, notamment la bobine 3, génère alors un champ magnétique alternatif H. La cible 4 se trouve donc dans un champ magnétique H variable dans le temps. Des courants de Foucault 11 schématiquement représentés sur la figure 4 sont alors induits à l'intérieur de la cible 4, qui se comporte comme un circuit électrique fermé.

La cible 4, qui est parcourue par les courants de Foucault 11, engendre un champ magnétique induit $H_i$ et une variation d'impédance $\delta Z$ du deuxième ensemble B. La variation d'impédance $\delta Z$ consiste en la différence entre l'impédance $Z_{cible}$ de l'élément inducteur 3 en présence de la cible 4, et notamment en présence du champ magnétique induit $H_i$, et l'impédance $Z_{air}$ de l'élément inducteur 3 en l'absence de la cible 4, c'est-à-dire lorsque l'élément inducteur 3 est uniquement entourée d'air. $Z_{air}$ peut notamment être directement mesurée à partir des signaux X2, Y2 de l'ensemble de référence R de la figure 3. Ainsi, la variation d'impédance $\delta Z$ d'une bobine 3 telle que décrite ci-dessus est plus particulièrement donnée par la relation suivante :

$$\delta Z = Z_{cible} - Z_{air} = -i\omega\mu0 \int_0^\infty \left[\frac{\chi(\alpha r1 - \alpha r2)}{\alpha^3}\right]^2 [e^{-\alpha l1} - e^{-\alpha l2}]A0(\alpha)d\alpha$$

avec r1 et r2 respectivement les rayons intérieur et extérieur de la bobine 3. 11, 12 correspondent aux distances respectivement entre l'extrémité avant 3a et l'extrémité arrière 3b de la bobine 3 par rapport à la cible 4 suivant la direction principale Z, tel que décrit ci-dessus. A0 traduit la dépendance aux propriétés de la cible 4 du champ magnétique dans le domaine contenant l'élément inducteur 3. En particulier, A0 varie en fonction de l'épaisseur e et de la conductivité de la cible 4. $\mu0$ est la perméabilité magnétique du vide et $\omega$ à une fréquence donnée. $\chi$ correspond à une intégrale de fonction de Bessel.

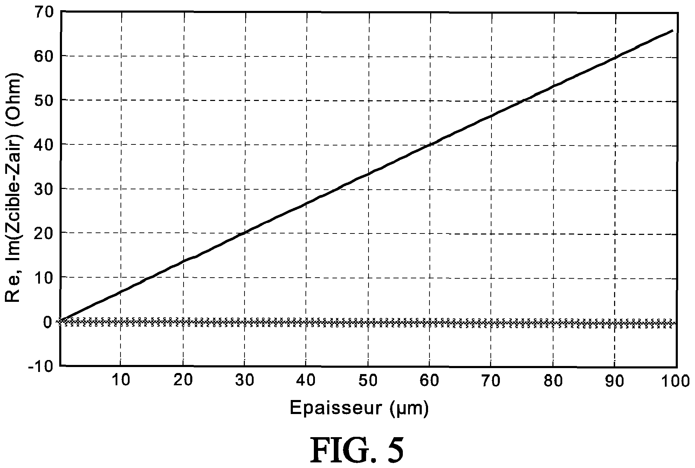

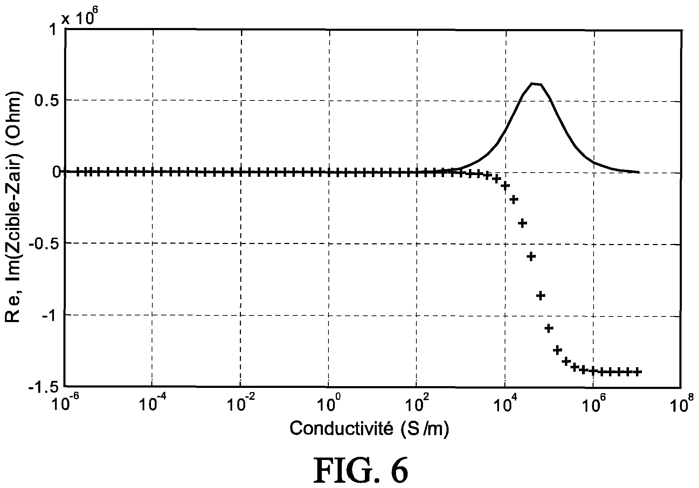

A une fréquence et à une distance 11 entre l'élément inducteur 3 et la cible 4 donnée, la variation d'impédance $\delta Z$ de la bobine 3 dépend donc de la conductivité et de l'épaisseur e de la cible 4 par l'intermédiaire de l'amplitude A0. Un exemple de relation entre la variation d'impédance $\delta Z$ et l'épaisseur e de la cible 4 est plus précisément illustré à la figure 5. Un exemple de relation entre la variation d'impédance $\delta Z$ et la conductivité de la cible 4 est plus précisément illustré à la figure 6. Sur ces deux figures 5 et 6, la courbe en trait continue et la courbe en croix correspondent respectivement aux valeurs de la partie réelle et de la partie imaginaire de la variation d'impédance $\delta Z$. Ces exemples des figures 5 et 6 sont donnés à titre purement illustratif et non limitatif.

Du fait de cette variation d'impédance $\delta Z$, le deuxième ensemble B comprenant l'élément inducteur 3 et la cible 4 réfléchit ou transmet ainsi une partie du signal vers l'ADC 2 du premier ensemble A à travers la ligne de transmission 5.

L'ADC 2 peut ainsi mesurer le signal réfléchi ou transmis Y par le deuxième ensemble B. En particulier, le signal réfléchi ou transmis Y est couplé par l'intermédiaire du système de couplage 6, notamment du deuxième système de couplage 6b, à l'ADC 2.

L'ADC 2 transmet alors le signal reçu Y au troisième ensemble C. Le troisième ensemble C analyse les signaux émis X et reçu Y transmis par le premier ensemble A et détermine le rapport Y/X du deuxième ensemble B sur la gamme de fréquences $\Delta f$. En particulier, le rapport de transformée de Fourier du signal reçu Y par rapport au signal émis X permet d'obtenir une mesure de ce rapport Y/X qui correspond soit à un coefficient de réflexion $\rho$, soit à un coefficient de transmission R en fréquence :

$$\rho, \ R = Y/X$$

L'impédance $Z_{cible}$ du deuxième ensemble B, et notamment de l'élément inducteur 3, est reliée au rapport Y/X, exprimé dans le plan d'une section de la ligne de transmission 5, par la relation :

$$\rho = (Z_{cible} - Z_{ligne}) / (Z_{cible} + Z_{ligne})$$

en réflexion

$$R = 2 \ Z_{cible} / (Z_{cible} + Z_{ligne})$$

en transmission

avec $Z_{ligne}$ qui désigne l'impédance de la ligne de transmission 5 et $Z_{cible}$ l'impédance de l'élément inducteur 3. Il est ainsi possible à partir du rapport Y/X de déterminer la variation d'impédance $\delta Z$ du deuxième ensemble B, et inversement.

On décrit maintenant plus en détails le troisième ensemble C.

Selon un premier mode de réalisation de l'invention, le troisième ensemble C comprend un système d'analyse 7. Le système d'analyse 7 utilise un modèle 8 reliant la variation d'impédance $\delta Z$ du deuxième ensemble B à la conductivité de la cible 4. Le modèle 8 peut notamment être approximée par étalonnage à partir d'un ensemble de cibles 4 de conductivité connues, constituées de différents matériaux de référence.

Le système d'analyse 7 détermine le rapport Y/X à partir du signal émis X et du signal reçu Y, puis détermine la variation d'impédance $\delta Z$ du deuxième ensemble B. Le modèle 8 permet ensuite, à partir de cette variation d'impédance $\delta Z$, de déduire la conductivité de la cible 4 sur la gamme de fréquence $\Delta f$.

Dans un second mode de réalisation, le système d'analyse 7 du troisième ensemble C utilise un modèle 8 de l'interaction électromagnétique entre l'élément inducteur 3 et la cible 4. Le système d'analyse 7 comprend alors également un algorithme de minimisation.

Ainsi, une valeur théorique d'entrée initiale de la conductivité de la cible 4 est transmise dans le modèle 8, de sorte qu'une variation d'impédance théorique est déduite à différentes fréquences de la gamme de fréquence $\Delta f$. Ces valeurs théoriques de la variation d'impédance sont comparées aux valeurs expérimentales mesurées de la variation d'impédance $\delta Z$ déterminées par le système d'analyse 7 sur la même gamme de fréquence $\Delta f$. La différence est calculée et la valeur d'entrée de conductivité du modèle 8 est ajustée de proche en proche par itération pour minimiser cette différence. La conductivité de la cible semi-conductrice 4 est ainsi déterminée. Cet ajustement itératif peut également être réalisé en comparant des valeurs des rapports Y/X expérimentales avec des valeurs de rapport Y/X théoriques.

En variante dans ce second mode de réalisation, on peut estimer à la fois la conductivité et l'épaisseur e d'une cible semi-conductrice par la méthode itérative.

Toujours en variante, on peut estimer par la méthode itérative une pluralité de paramètres de la cible 4. Il est par exemple possible de mesurer la/les conductivités et/ou la/les épaisseurs d'une cible 4 comprenant un matériau multicouches et/ou non homogène. En effet, en modifiant la fréquence du signal émis X vers le deuxième ensemble B, il est possible de modifier l'épaisseur de pénétration du champ magnétique H dans la cible 4. Ainsi, le signal reçu Y est nécessairement dépendant de la première couche de la cible 4, mais peut ne pas être dépendant de toutes les couches de la cible 4. En faisant varier la fréquence du signal émis X et donc la profondeur de pénétration du champ magnétique H, il est possible de reconstruire un profil de conductivité de la cible 4 pour différentes couches d'un matériau multicouches ou pour différentes zones d'un matériau non homogène.

Toujours selon ce second mode de réalisation, dans le cas par exemple d'une cible 4 monocouche dont on souhaite déterminer l'épaisseur e et la conductivité, ces deux paramètres sont initialement estimés ou sélectionnés aléatoirement, puis transmis comme valeurs d'entrée initiales dans le modèle 8 du troisième ensemble C. Les mesures du rapport Y/X pour ces deux paramètres pour M fréquences différentes sont alors comparées au résultat de la mesure expérimentale pour ces M fréquences.

Les valeurs d'entrée du modèle 8, notamment l'épaisseur e et la conductivité, sont alors modifiées de manière itérative via l'algorithme de minimisation jusqu'à l'atteinte d'un critère d'arrêt, par exemple jusqu'à ce que l'écart entre les valeurs de sortie du modèle 8 et le résultat de mesures expérimentales soit inférieur à une tolérance prédéfinie. Les valeurs d'entrée initiales du modèle 8 peuvent être choisies arbitrairement, notamment aléatoirement. En particulier, le modèle 8 est adapté pour converger vers des valeurs de sortie finales. Les valeurs de sortie finales du modèle 8 fournissent alors une estimation des paramètres épaisseur e et conductivité de la cible 4. En particulier, dans le cas où la cible 4 est monocouche et d'épaisseur e connue, la situation est identique, un seul paramètre, à savoir la conductivité, étant à déterminer.

De façon générale, ce procédé de mesure peut être généralisé à N paramètres à déterminer et M fréquences de mesures, avec le nombre de fréquences de mesure M supérieur ou égal au nombre N de paramètres à déterminer. En outre, étant donné que chaque fréquence de mesure M permet de déterminer distinctement la partie réelle et la partie imaginaire d'un signal, il peut être également possible de déterminer N paramètres si le nombre de fréquences de mesure M est supérieur ou égal à N/2 paramètres à déterminer.

Les conditions aux limites dans le modèle 8 sont adaptées à la cible 4. La géométrie complète de la cible 4 est en particulier prise en compte comme valeurs du modèle 8. L'épaisseur e minimale de la cible 4 pouvant être prise en compte dans le modèle 8 est, par exemple inférieur à $1\mu m$, voire de l'ordre de 10nm. La distance 11 est également prise en compte et compensé dans le modèle 8 pour tenir compte des pertes de champ.

Dans ce second mode de réalisation, on peut également envisager de mesurer plusieurs cibles 4 à la fois. En variante une cible 4 peut être testée par zones, en plusieurs fois.

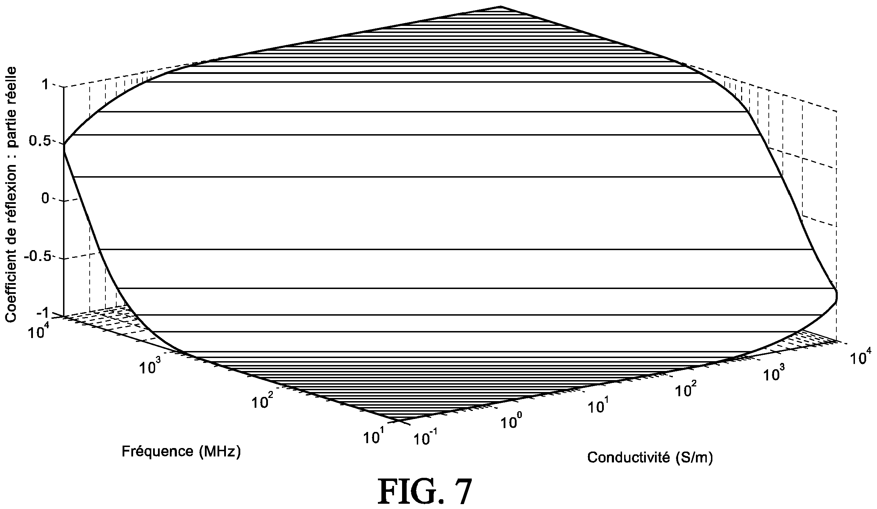

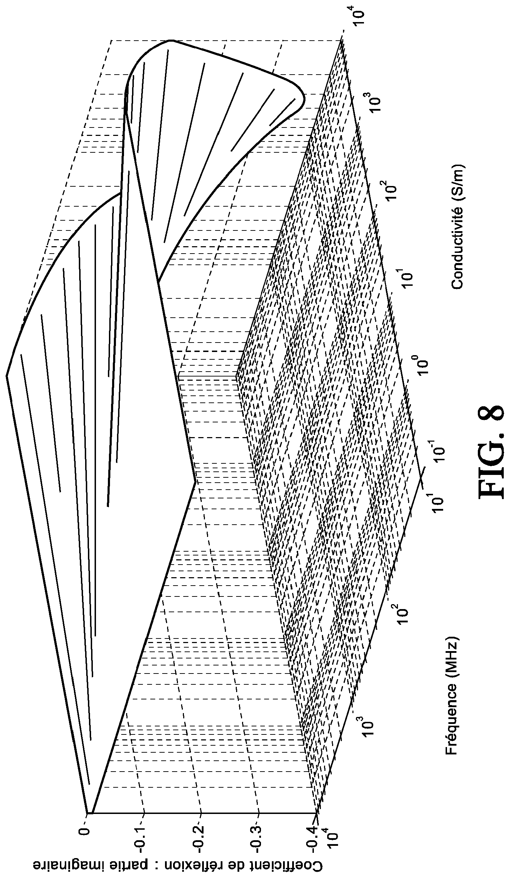

Comme illustré sur les figures 7 et 8, pour une conductivité et une épaisseur e donnée d'une cible 4, il existe une gamme de fréquence $\Delta f$ dans laquelle la sensibilité de mesure est optimale. En particulier, par « sensibilité de mesure optimale », on entend que le rapport Y/X comprend une partie réelle et/ou une partie imaginaire variant respectivement de façon maximale autour d'une fréquence de mesure particulière.

A chaque conductivité de couche de la cible 4 à mesurer, il existe donc une gamme de fréquence $\Delta f$, notamment autour de la fréquence de mesure particulière, dans laquelle la sensibilité de mesure est maximale.

Plus la conductivité de la cible 4 est faible, plus il est nécessaire d'utiliser un signal émis X ayant des fréquences élevées pour obtenir une sensibilité de mesure optimale. Ainsi, la caractérisation de cible 4 comportant une/des couche(s) de faible conductivité et de faible épaisseur sera avantageusement améliorée avec l'utilisation d'un signal émis X ayant des fréquences élevées. De plus, une conductivité élevée de la cible 4 entraine une faible variation du rapport Y/X pour des fréquences élevées.

La gamme de fréquences $\Delta f$ peut être comprise entre 100kHz à 2 GHz, voire comprise entre 100kHz à 300MHz. Une carte circuit logique programmable (« field-programmable gâte array » FPGA) ou un processeur rapide couplé à des convertisseurs numérique/analogique et analogique/numérique rapide peuvent être utilisés pour balayer rapidement une grande gamme de fréquence $\Delta f$.

La conductivité d'un grand nombre de matériaux peut être estimée par cette méthode, tels que le silicium, ainsi que des composés comme le CIGS, le CdTe, des matériaux organiques, de nouveaux matériaux organiques tels que des perovskytes, des couches telles que celles à base de matériaux III-V utilisées dans des multi-jonctions p-n. En variante, le procédé est utilisé pour optimiser des traitements de surface de multicouches/multi-jonctions.

La ou les épaisseurs des matériaux semi-conducteurs de la cible 4 peuvent être adapté pour des applications en électronique, en particulier dans le domaine du photovoltaïque. Ces épaisseurs varient usuellement d'environ 50nm à quelques micromètres pour des matériaux en couches minces, et de quelques dizaines de micromètres à quelques centaines de micromètres pour des matériaux massifs, comme le silicium cristallin par exemple. Leurs conductivités peuvent varier de $10^{-3}$ S.m$^{-1}$ à $10^4$ S.m$^{-1}$. Ces valeurs de conductivité recouvrent la gamme typique de conductivités des différents types de matériaux semi-conducteurs, en particulier ceux utilisés pour le photovoltaïque, selon qu'ils se présentent sous forme de couches minces, ou sous forme de plaquettes autosupportées.

Le dispositif est par exemple utilisé pour le contrôle non destructif de matériau de la cible 4.

En variante, le deuxième ensemble B, et notamment la cible 4, peut être utilisé en solution ou noyé dans de la céramique pour être utilisé dans des environnements sous fortes contraintes thermiques ou chimiques puisqu'un semi-conducteur est sensible aux conditions environnantes.

En variante, la cible 4 peut être utilisée en bain chimique.

Le dispositif de mesure permet de mesurer la conductivité de la cible 4 dans l'obscurité. Une référence de mesure à l'obscurité peut notamment être utilisée pour permettre une mesure plus sensible de la conductivité et/ou de l'épaisseur e de cibles 4 comportant un ou plusieurs matériaux peu photoconducteurs.

Le dispositif de mesure permet également de mesurer la conductivité lorsque la cible 4, et notamment sa première surface 4a et/ou sa deuxième face 4b, est soumise à un éclairement. Dans le cas où la cible 4 est utilisée sous éclairement, le dispositif de mesure peut ainsi permettre de mesurer des valeurs de conductivité selon un régime dépendant du temps. Selon ce régime dépendant du temps, les valeurs de conductivité auquel est soumise la cible 4 peuvent être reliées à la durée de vie des porteurs de charge de la cible 4.

Il est alors nécessaire que le procédé et le dispositif de mesure soit suffisamment rapide afin de détecter la durée de vie des porteurs de charges en régime dépendant du temps. Selon cette réalisation, le procédé de mesure peut ainsi comprendre une carte FGPA ou un processeur rapide couplé à des convertisseurs numérique/analogique et analogique/numérique rapide, comme décrits ci-dessus. Une carte FPGA permet notamment d'obtenir un procédé de mesure très rapide permettant de mesurer des temps de vie courts de porteurs de charge de la cible 4 ou d'être intégrée à une chaîne de mesure.

Ainsi, il est possible de combiner lors du procédé de mesure, l'émission d'un signal X tel que décrit ci-dessus avec un éclairement de la cible 4. Une telle combinaison permet notamment d'augmenter la sensibilité de la mesure de la conductivité de la cible 4, notamment pour une cible 4 multicouche.

En outre, un traitement d'une surface de la cible 4, notamment de la première surface 4a, peut être réalisé pour modifier le temps de vie des porteurs de charge de la cible 4.

Bien évidemment, l'invention n'est pas limitée aux modes de réalisation décrits précédemment et fournis uniquement à titre d'exemple. Elle englobe diverses modifications, formes alternatives et autres variantes que pourra envisager l'homme du métier dans le cadre de la présente invention et notamment toutes combinaisons des différents modes de fonctionnement du dispositif et/ou du procédé décrits précédemment, pouvant être pris séparément ou en association.

## Revendications

1. Procédé de mesure sans contact de la conductivité de semi-conducteurs, ledit procédé étant mis en œuvre par :

   - un premier ensemble (A) comprenant un système d'émission/réception de signal (X, Y) apte à émettre/recevoir un signal (X, Y) multi-fréquentiel sur une gamme de fréquences ($\Delta f$), le signal émis (X) multi-fréquentiel étant de la forme :

$$x(t) = \sum_{i=1}^{N/2} a_i \cos\left(\frac{2\pi i}{NT_e} t + \varphi_i\right)$$

   avec i qui représente l'indice de la ième fréquence, Te la période d'émission des échantillons, ai l'amplitude de N/2 fréquences et $\varphi_i$ leurs phases respectives,
   - un deuxième ensemble (B) comprenant au moins une cible semi-conductrice (4) et un unique élément inducteur (3), la cible semi-conductrice (4) étant positionnée à proximité de l'élément inducteur (3),
   - une ligne de transmission (5), ladite ligne de transmission (5) étant adaptée pour transmettre le signal (X, Y) entre le premier ensemble (A) et le deuxième ensemble (B), et
   - un troisième ensemble (C), ledit troisième ensemble (C) étant destiné à être connecté au premier ensemble (A), le troisième ensemble (C) comprenant un système d'analyse (7), le troisième ensemble (C) étant apte à analyser un signal émis (X) par le premier ensemble (A) et un signal réfléchi ou transmis (Y) reçu par le premier ensemble (A) et le troisième ensemble (C) étant apte à en déduire un coefficient de réflexion ou de transmission ($\rho$, R) du signal émis (X),

   ledit procédé comprenant au moins les étapes suivantes:

   a) Le premier ensemble (A) émet un signal multi-fréquentiel (X),
   b) Le deuxième ensemble (B) réfléchit ou transmet au moins une partie du signal multi-fréquentiel émis (X) par le premier ensemble (A),
   c) Le premier ensemble (A) reçoit le signal multi-fréquentiel réfléchi ou transmis (Y) par le deuxième ensemble (B),
   d) Le troisième ensemble (C) calcule le coefficient de réflexion ou de transmission ($\rho$, R) du signal émis (X) pour la gamme de fréquences ($\Delta f$) à partir du rapport entre le signal émis par le premier ensemble (A) et le signal réfléchis ou transmis par le deuxième ensemble (B),
   e) Le troisième ensemble (C) détermine la conductivité de la cible semi-conductrice (4) en utilisant la variation d'impédance sur la gamme de fréquences ($\Delta f$) du deuxième ensemble (B) obtenue à partir dudit rapport.

2. Procédé de mesure sans contact selon la revendication 1, dans lequel le système d'analyse (7) du troisième ensemble (C) utilise un modèle (8) reliant la variation d'impédance (5Z) du deuxième ensemble (B) à la conductivité de la cible (4), l'étape e) du procédé comprenant préalablement les étapes suivantes réalisées par le troisième ensemble (C) :

   e1) à partir de la valeur du coefficient de réflexion ou de transmission ($\rho$, R), déterminer la variation d'impédance ($\delta Z$) du deuxième ensemble (B) sur la gamme de fréquences ($\Delta f$),
   e2) avec le modèle (8), en déduire la conductivité de la cible à partir de la variation d'impédance ($\delta Z$) du deuxième ensemble (B).

3. Procédé de mesure sans contact selon la revendication 1, dans lequel le système d'analyse (7) du troisième ensemble (C) utilise un modèle (8) de l'interaction électromagnétique entre l'élément inducteur (3) et la cible semi-conductrice (4) et un algorithme de minimisation, l'étape e) du procédé étant effectuée par méthode itérative selon les étapes suivantes :

e'1) à partir de la valeur du coefficient de réflexion ou de transmission ($\rho$, R), déterminer la variation d'impédance ($\delta Z$) du deuxième ensemble (B) sur la gamme de fréquences ($\Delta f$),

e'2) fournir une valeur d'entrée initiale de conductivité théorique de la cible (4) dans le modèle (8),

e'3) évaluer à partir du modèle (8) la variation d'impédance ($\delta Z$) du deuxième ensemble (B) théorique pour la gamme de fréquences ($\Delta f$),

e'4) évaluer la différence entre la variation d'impédance ($\delta Z$) du deuxième ensemble (B) théorique et la variation d'impédance ($\delta Z$) du deuxième ensemble (B) mesurée,

e'5) minimiser ladite différence.

4. Procédé de mesure sans contact selon la revendication 3, adapté pour déterminer plusieurs conductivités simultanément d'une cible semi-conductrice (4) multicouche ou pour la mesure de plusieurs cibles semi-conductrices (4).

5. Procédé de mesure sans contact selon la revendication 4, adapté pour déterminer l'épaisseur (e) de chacune des couches de la cible semi-conductrice (4) multicouche.

6. Procédé de mesure sans contact selon l'une quelconque des revendications précédentes, dans lequel le premier ensemble (A) comprend au moins un convertisseur numérique analogique (1), ledit convertisseur étant adapté pour émettre le signal multi-fréquentiel (X), le premier ensemble (A) comprenant également un système d'acquisition convertisseur analogique numérique (2), ledit système d'acquisition (2) étant adapté pour recevoir le signal multi-fréquentiel réfléchi ou transmis (Y) .

7. Procédé de mesure sans contact selon la revendication 6, dans lequel le premier ensemble (A) comprend au moins un système de couplage (6), ledit système de couplage (6) étant adapté pour coupler le signal émis (X) par le convertisseur numérique analogique (1) dans la ligne de transmission (5), et coupler le signal réfléchi ou transmis (Y) vers le système d'acquisition convertisseur analogique numérique (2).

8. Procédé de mesure sans contact selon la revendication 6, dans lequel le premier ensemble (A) comprend au moins deux systèmes de couplage (6), un premier système de couplage (6a) étant adapté pour coupler le signal émis (X) par le convertisseur numérique analogique (1) dans une première ligne de transmission (5a), et un deuxième système de couplage (6b) étant adapté pour coupler le signal réfléchi ou transmis (Y) dans une deuxième ligne de transmission (5b) vers le système d'acquisition convertisseur analogique numérique (2).

9. Procédé de mesure sans contact selon l'une quelconque des revendications précédentes, dans lequel la gamme de fréquence ($\Delta f$) du signal émis (X) est comprise entre 100kHz et 300MHz.

10. Procédé de mesure sans contact selon l'une quelconque des revendications précédentes, dans lequel la gamme de fréquence ($\Delta f$) est choisie de sorte que les variations du coefficient de réflexion ou de transmission ($\rho$, R) sont maximales pour une variation donnée de conductivité autour d'une fréquence de mesure particulière.

11. Dispositif de mesure sans contact de la conductivité de semi-conducteur **caractérisé en ce qu'**il comprend :

- un premier ensemble (A), ledit premier ensemble (A) étant un système d'émission/réception de signal (X, Y) apte à émettre/recevoir un signal (X, Y) multi-fréquentiel sur une gamme de fréquences ($\Delta f$), le signal émis (X) multi-fréquentiel étant de la forme :

$$x(t) = \sum_{i=1}^{\frac{N}{2}} a_i \cos\left(\frac{2\pi i}{NT_e}t + \varphi_i\right)$$

avec i qui représente l'indice de la ième fréquence, Te la période d'émission des échantillons, ai l'amplitude de N/2 fréquences et $\varphi_i$ leurs phases respectives,

- un deuxième ensemble (B), ledit deuxième ensemble (B) comprenant au moins une cible semi-conductrice (4) et un unique élément inducteur (3), la cible semi-conductrice (4) étant positionnée à proximité de l'élément inducteur (3),

- au moins une ligne de transmission (5), ladite ligne de transmission (5) étant adaptée pour transmettre le signal (X, Y) entre le premier ensemble (A) et le deuxième ensemble (B),
- un troisième ensemble (C), ledit troisième ensemble (C) étant destiné à être connecté au premier ensemble (A), le troisième ensemble (C) comprenant un système d'analyse (7), le troisième ensemble (C) étant apte à analyser un signal émis (X) et un signal réfléchi ou transmis (Y) reçu par le premier ensemble (A) et le troisième ensemble (C) étant apte à en déduire un coefficient de réflexion ou de transmission ($\rho$, R) du signal émis (X) pour la gamme de fréquences ($\Delta$f) à partir du rapport entre le signal émis par le premier ensemble (A) et le signal réfléchi ou transmis par le deuxième ensemble (B) et à déterminer la conductivité de la cible semi-conductrice (4) en utilisant la variation d'impédance sur la gamme de fréquences ($\Delta$f) du deuxième ensemble (B) obtenue à partir dudit rapport.

12. Dispositif de mesure sans contact selon la revendication 11, dans lequel l'élément inducteur (3) est imprimé sur un circuit, ledit circuit étant positionné à proximité de la cible semi-conductrice (4) .

13. Dispositif de mesure sans contact selon l'une quelconque des revendications 11 et 12, dans lequel l'élément inducteur (3) est une bobine comprenant un rayon intérieur (r1) et un rayon extérieur (r2), et dans lequel la cible semi-conductrice (4) s'étend dans un plan (P) perpendiculaire à une direction principale (Z) de l'élément inducteur (3) suivant deux dimensions (L1, L2), les rayons intérieur et extérieur (r1, r2) de l'élément inducteur (3) étant inférieurs aux dimensions (L1, L2) de la cible semi-conductrice (4), voire de l'ordre de la moitié des dimensions (L1, L2) de la cible (4).

**Patentansprüche**

1. Verfahren zur berührungslosen Messung der Leitfähigkeit von Halbleitern, wobei das Verfahren implementiert wird durch:

- eine erste Baugruppe (A), die ein System zum Senden/Empfangen eines Signals (X, Y) umfasst, das dazu geeignet ist, ein multi-frequenzielles Signal (X, Y) über einen Frequenzbereich ($\Delta$f) zu senden/empfangen, wobei das gesendete multi-frequenzielle Signal (X) so geformt ist:

$$x(t) = \sum_{i=1}^{N/2} a_i \cos\left(\frac{2\pi i}{NT_e}t + \varphi_i\right)$$

wobei i den Index der -ten Frequenz, Te die Sendeperiode der Abtastungen, ai die Amplitude von N/2 Frequenzen und $\varphi i$ ihre jeweiligen Phasen darstellt,
- eine zweite Baugruppe (B), die mindestens ein Halbleiterziel (4) und ein einzelnes Induktionselement (3) umfasst, wobei das Halbleiterziel (4) in der Nähe des Induktionselements (3) angeordnet ist,
- eine Übertragungsleitung (5), wobei die Übertragungsleitung (5) zur Übertragung des Signals (X, Y) zwischen der ersten Baugruppe (A) und der zweiten Baugruppe (B) ausgelegt ist, und
- eine dritte Baugruppe (C), wobei die dritte Baugruppe (C) dazu vorgesehen ist, mit der ersten Baugruppe (A) verbunden zu werden, wobei die dritte Baugruppe (C) ein Analysesystem (7) umfasst, wobei die dritte Baugruppe (C) dazu geeignet ist, ein durch die erste Baugruppe (A) gesendetes Signal (X) zu analysieren, und ein reflektiertes oder übertragenes Signals (Y), das von der ersten Baugruppe (A) empfangen wurde, und die dritte Baugruppe (C) dazu geeignet ist, daraus einen Reflexions- oder Übertragungskoeffizienten ($\rho$, R) des gesendeten Signals (X) abzuleiten,

wobei das Verfahren mindestens die folgenden Schritte umfasst:

a) die erste Baugruppe (A) sendet ein multi-frequenzielles Signal (X),
b) die zweite Baugruppe (B) reflektiert oder überträgt mindestens einen Teil des multifrequenziellen Signals (X), das von der ersten Baugruppe (A) gesendet wurde,

c) die erste Baugruppe (A) empfängt das multi-frequenzielle Signal, das von der zweiten Baugruppe (B) reflektiert oder übertragen (Y) wurde,

d) die dritte Baugruppe (C) berechnet den Reflexions- oder Übertragungskoeffizienten ($\rho$, R) des gesendeten Signals (X) für den Frequenzbereich ($\Delta$f) ausgehend vom Verhältnis zwischen dem von der ersten Baugruppe (A) gesendeten Signal und dem Signal, das von der zweiten Baugruppe (B) reflektiert oder übertragen wurde,

e) die dritte Baugruppe (C) bestimmt die Leitfähigkeit des Halbleiterziels (4) unter Verwendung der Änderung der Impedanz über den Frequenzbereich ($\Delta$f) der zweiten Baugruppe (B), die ausgehend vom Verhältnis erhalten wurde.

2. Berührungsloses Messverfahren nach Anspruch 1, wobei das Analysesystem (7) der dritten Baugruppe (C) ein Modell (8) verwendet, das die Änderung der Impedanz ($\delta$Z) der zweiten Baugruppe (B) mit der Leitfähigkeit des Ziels (4) verbindet, wobei der Schritt e) des Verfahrens vorgängig die folgenden Schritte umfasst, die von der dritten Baugruppe (C) ausgeführt werden:

e1) ausgehend vom Wert des Reflexions- oder Übertragungskoeffizienten ($\rho$, R), Bestimmen der Änderung der Impedanz ($\delta$Z) der zweiten Baugruppe (B) über den Frequenzbereich ($\Delta$f),

e2) mit dem Modell (8), Ableiten der Leitfähigkeit des Ziels ausgehend von der Impedanz ($\delta$Z) der zweiten Baugruppe (B).

3. Berührungsloses Messverfahren nach Anspruch 1, wobei das Analysesystem (7) der dritten Baugruppe (C) ein Modell (8) der elektromagnetischen Wechselwirkung zwischen dem Induktionselement (3) und dem Halbleiterziel (4) verwendet, und ein Algorithmus des Schritts e) des Verfahrens mittels iterativer Methode nach den folgenden Schritten durchgeführt wird:

e'1) ausgehend vom Wert des Reflexions- oder Übertragungskoeffizienten ($\rho$, R), Bestimmen der Änderung der Impedanz ($\delta$Z) der zweiten Baugruppe (B) über den Frequenzbereich ($\Delta$f),

e'2) Bereitstellen eines initialen Eingangswerts der theoretischen Leitfähigkeit des Ziels (4) im Modell (8),

e'3) Bewerten, ausgehend vom Modell (8), der theoretischen Änderung der Impedanz ($\delta$Z) der zweiten Baugruppe (B) für den Frequenzbereich ($\Delta$f),

e'4) Bewerten der Differenz zwischen der theoretischen Änderung der Impedanz ($\delta$Z) der zweiten Baugruppe (B) und der gemessenen Änderung der Impedanz ($\delta$Z) der zweiten Baugruppe (B),

e'5) Minimieren der Differenz.

4. Berührungsloses Messverfahren nach Anspruch 3, das ausgelegt ist, um gleichzeitig mehrere Leitfähigkeiten eines mehrschichtigen Halbleiterziels (4) zu bestimmen oder um mehrerer Halbleiterziele (4) zu messen.

5. Berührungsloses Messverfahren nach Anspruch 4, das ausgelegt ist, um die Dicke (e) jeder der Schichten des mehrschichtigen Halbleiterziels (4) zu bestimmen.

6. Berührungsloses Messverfahren nach einem der vorhergehenden Ansprüche, wobei die erste Baugruppe (A) mindestens einen Digital-Analog-Wandler (1) umfasst, wobei der Wandler ausgelegt ist, um das multi-frequenzielle Signal (X) zu senden, wobei die erste Baugruppe (A) auch ein Digital-Analog-Wandler-Erfassungssystem (2) umfasst, wobei das Erfassungssystem (2) ausgelegt ist, um das reflektierte oder übertragene multi-frequenzielle Signal (Y) zu empfangen.

7. Berührungsloses Messverfahren nach Anspruch 6, wobei die erste Baugruppe (A) mindestens ein Kopplungssystem (6) umfasst, wobei das Kopplungssystem (6) ausgelegt ist, um das vom Digital-Analog-Wandler (1) gesendete Signal (X) in die Übertragungsleitung (5) zu koppeln und das reflektierte oder übertragene Signal (Y) an das Digital-Analog-Wandler-Erfassungssystem (2) zu koppeln.

8. Berührungsloses Messverfahren nach Anspruch 6, wobei die erste Baugruppe (A) mindestens zwei Kopplungssysteme (6) umfasst, wobei ein erstes Kopplungssystem (6a) ausgelegt ist, um das vom Digital-Analog-Wandler (1) gesendete Signal (X) in einer ersten Übertragungsleitung (5a) zu koppeln, und ein zweites Kopplungssystem (6b) ausgelegt ist, um das reflektierte oder übertragene Signal (Y) in einer zweiten Übertragungsleitung (5b) an das Digital-Analog-Wandler-Erfassungssystem (2) zu koppeln.

9. Berührungsloses Messverfahren nach einem der vorhergehenden Ansprüche, wobei der Frequenzbereich ($\Delta$f) des gesendeten Signals (X) zwischen 100 kHz und 300 MHz liegt.

**10.** Berührungsloses Messverfahren nach einem der vorhergehenden Ansprüche, wobei der Frequenzbereich (Δf) so gewählt ist, dass die Änderungen des Reflexions- oder Übertragungskoeffizienten (ρ, R) für eine gegebene Änderung der Leitfähigkeit um eine besondere Messfrequenz maximal sind.

**11.** Berührungslose Messvorrichtung der Halbleiter-Leitfähigkeit, **dadurch gekennzeichnet, dass** sie umfasst:

- eine erste Baugruppe (A), wobei die erste Baugruppe (A) ein System zum Senden/Empfangen eines Signals (X, Y) ist, das dazu geeignet ist, ein multi-frequenzielles Signal (X, Y) über einen Frequenzbereich (Δf) zu senden/empfangen, wobei das gesendete multi-frequenzielle Signal (X) so geformt ist:

$$x(t) = \sum_{i=1}^{N/2} a_i \cos\left(\frac{2\pi i}{NT_e} t + \varphi_i\right)$$

wobei i den Index der -ten Frequenz, Te die Sendeperiode der Abtastungen, ai die Amplitude von N/2 Frequenzen und $\varphi i$ ihre jeweiligen Phasen darstellt,
- eine zweite Baugruppe (B), wobei die zweite Baugruppe (B) mindestens ein Halbleiterziel (4) und ein einzelnes Induktionselement (3) umfasst, wobei das Halbleiterziel (4) in der Nähe des Induktionselements (3) angeordnet ist,
- mindestens eine Übertragungsleitung (5), wobei die Übertragungsleitung (5) zur Übertragung des Signals (X, Y) zwischen der ersten Baugruppe (A) und der zweiten Baugruppe (B) ausgelegt ist,
- eine dritte Baugruppe (C), wobei die dritte Baugruppe (C) dazu vorgesehen ist, mit der ersten Baugruppe (A) verbunden zu werden, wobei die dritte Baugruppe (C) ein Analysesystem (7) umfasst, wobei die dritte Baugruppe (C) dazu geeignet ist, ein gesendetes Signal (X) zu analysieren und ein reflektiertes oder übertragenes Signal (Y), das von der ersten Baugruppe (A) empfangen wurde, und die dritte Baugruppe (C) dazu geeignet ist, daraus einen Reflexions- oder Übertragungskoeffizienten (ρ, R) des gesendeten Signals (X) abzuleiten für den Frequenzbereich (Δf) ausgehend vom Verhältnis zwischen dem von der ersten Baugruppe (A) gesendeten Signal und dem Signal, das von der zweiten Baugruppe (B) reflektiert oder übertragen wurde, und die Leitfähigkeit des Halbleiterziels (4) zu bestimmen unter Verwendung der Änderung der Impedanz über den Frequenzbereich (Δf) der zweiten Baugruppe (B), die ausgehend vom Verhältnis erhalten wurde.

**12.** Berührungslose Messvorrichtung nach Anspruch 11, wobei das Induktionselement (3) auf einer Schaltung aufgedruckt ist, wobei die Schaltung in der Nähe des Halbleiterziels (4) angeordnet ist.

**13.** Berührungslose Messvorrichtung nach einem der Ansprüche 11 und 12, wobei das Induktionselement (3) eine Spule ist, die einen Innenradius (r1) und einen Außenradius (r2) umfasst, und wobei sich das Halbleiterziel (4) in einer Ebene (P) senkrecht zu einer Hauptrichtung (Z) des Induktionselements (3) in zwei Dimensionen (L1, L2) erstreckt, wobei der Innen- und der Außenradius (r1, r2) des Induktionselements (3) kleiner als die Abmessungen (L1, L2) des Halbleiterziels (4) sind oder sogar in der Größenordnung der Hälfte der Abmessungen (L1, L2) des Ziels (4).

## Claims

**1.** A method for contactless measurement of the conductivity of semiconductors, said method being implemented by:

- a first assembly (A) comprising a signal (X, Y) transmission/reception system able to transmit/receive a multi-frequency signal (X, Y) over a frequency range (Δf), the multi-frequency signal (X) transmitted being in the form:

$$x(t) = \sum_{i=1}^{N/2} a_i \cos\left(\frac{2\pi i}{NT_e} t + \varphi_i\right)$$

with i representing the index of the ith frequency, Te the sample transmission period, $a_i$ the amplitude of N/2 frequencies and $\varphi_i$ their respective phases,

- a second assembly (B) comprising at least one semiconducting target (4) and a single inductor element (3), the semiconducting target (4) being positioned in proximity to the inductor element (3),
- a transmission line (5), said transmission line (5) being adapted to transmit the signal (X, Y) between the first assembly (A) and the second assembly (B), and
- a third assembly (C), said third assembly (C) being intended to be connected to the first assembly (A), the third assembly (C) comprising an analysis system (7), the third assembly (C) being able to analyse a signal (X) transmitted by the first assembly (A) and a reflected or transmitted signal (Y) received by the first assembly (A), and the third assembly (C) being able to deduce a reflection or transmission coefficient ($\rho$, R) of the transmitted signal (X) therefrom,

said method comprising at least the following steps:

a) the first assembly (A) transmits a multi-frequency signal (X),
b) the second assembly (B) reflects or transmits at least one part of the multi-frequency signal (X) transmitted by the first assembly (A),
c) the first assembly (A) receives the multi-frequency signal (Y) reflected or transmitted by the second assembly (B),
d) the third assembly (C) calculates the reflection or transmission coefficient ($\rho$, R) of the signal (X) transmitted for the frequency range ($\Delta$f) from the ratio of the signal transmitted by the first assembly (A) to the signal reflected or transmitted by the second assembly (B),
e) the third assembly (C) determines conductivity of the semiconducting target (4) using the impedance variation over the frequency range ($\Delta$f) of the second assembly (B) obtained from said ratio.

2. The non-contact measurement method according to claim 1, wherein the analysis system (7) of the third assembly (C) uses a model (8) relating the impedance variation ($\delta$Z) of the second assembly (B) to the conductivity of the target (4), step e) of the method comprising beforehand the following steps performed by the third assembly (C):

e1) from the value of the reflection or transmission coefficient ($\rho$, R), determining the impedance variation ($\delta$Z) of the second assembly (B) over the frequency range ($\Delta$f),
e2) using model (8), deduce conductivity of the target from the impedance variation ($\delta$Z) of the second assembly (B) therefrom.

3. The non-contact measurement method according to claim 1, wherein the analysis system (7) of the third assembly (C) uses a model (8) of electromagnetic interaction between the inductor element (3) and the semiconducting target (4) and a minimisation algorithm, step e) of the method being carried out iteratively according to the following steps:

e'1) from the value of the reflection or transmission coefficient ($\rho$, R), determining the impedance variation ($\delta$Z) of the second assembly (B) over the frequency range ($\Delta$f),
e'2) providing an initial input value of theoretical conductivity of the target (4) in the model (8),
e'3) evaluating from the model (8) the theoretical impedance variation ($\delta$Z) of the second assembly (B) for the frequency range ($\Delta$f),
e'4) evaluating the difference between the theoretical impedance variation (5Z) of the second assembly (B) and the measured impedance variation ($\delta$Z) of the second assembly (B),
e'5) minimising said difference.

4. The non-contact measurement method according to claim 3, adapted to determine simultaneously several conductivities of a multilayer semiconducting target (4) or to measure several semiconducting targets (4).

5. The non-contact measurement method according to claim 4, adapted to determine the thickness (e) of each of the layers of the multilayer semiconducting target (4).

6. The non-contact measurement method according to any of the preceding claims, wherein the first assembly (A) comprises at least one analogue digital converter (1), said converter being adapted to transmit the multi-frequency signal (X), the first assembly (A) also comprising an analogue digital converter acquisition system (2), said acquisition system (2) being adapted to receive the multi-frequency reflected or transmitted signal (Y).

7. The non-contact measurement method according to claim 6, wherein the first assembly (A) comprises at least one coupling system (6), said coupling system (6) being adapted to couple the signal (X) transmitted by the digital analogue converter (1) in the transmission line (5), and to couple the signal reflected or transmitted (Y) to the analogue digital converter acquisition system (2).

8. The non-contact measurement method according to claim 6, wherein the first assembly (A) comprises at least two coupling systems (6), a first coupling system (6a) being adapted to couple the signal transmitted (X) by the digital analogue converter (1) in a first transmission line (5a), and a second coupling system (6b) being adapted to couple the signal reflected or transmitted (Y) in a second transmission line (5b) to the digital analogue converter acquisition system (2).

9. The non-contact measurement method according to any of the preceding claims, wherein the frequency range ($\Delta f$) of the transmitted signal (X) is between 100 kHz and 300 MHz.

10. The non-contact measurement method according to any of the preceding claims, wherein the frequency range (Af) is chosen so that the variations in the reflection or transmission coefficient ($\rho$, R) are maximum for a given variation in conductivity around a particular measurement frequency.

11. A device for non-contact measurement of the conductivity of a semiconductor, **characterised in that** it comprises:

- a first assembly (A), said first assembly (A) being a signal (X, Y) transmission/reception system able to transmit/receive a multi-frequency signal (X, Y) over a frequency range ($\Delta f$), the multi-frequency signal (X) transmitted being in the form:

$$x(t) = \sum_{i=1}^{\frac{N}{2}} a_i \cos\left(\frac{2\pi i}{NT_e}t + \varphi_i\right)$$

with i representing the index of the ith frequency, Te the sample transmission period, $a_i$ the amplitude of N/2 frequencies and $\varphi_i$ their respective phases,
- a second assembly (B), said second assembly (B) comprising at least one semiconducting target (4) and a single inductor element (3), the semiconducting target (4) being positioned in proximity to the inductor element (3),
- at least one transmission line (5), said transmission line (5) being adapted to transmit the signal (X, Y) between the first assembly (A) and the second assembly (B),
- a third assembly (C), said third assembly (C) being intended to be connected to the first assembly (A), the third assembly (C) comprising an analysis system (7), the third assembly (C) being able to analyse a transmitted signal (X) and a reflected or transmitted signal (Y) received by the first assembly (A) and the third assembly (C) being able to deduce therefrom a reflection or transmission coefficient ($\rho$, R) of the transmitted signal (X) for the frequency range ($\Delta f$) from the ratio of the signal transmitted by the first assembly (A) to the signal reflected or transmitted by the second assembly (B) and to determine conductivity of the semiconducting target (4) using the impedance variation over the frequency range ($\Delta f$) of the second assembly (B) obtained from said ratio.

12. The non-contact measurement device according to claim 11, wherein the inductor element (3) is printed on a circuit, said circuit being positioned in proximity to the semiconducting target (4).

13. The non-contact measurement device according to any of claims 11 and 12, wherein the inductor element (3) is a coil comprising an internal radius (r1) and an external radius (r2), and wherein the semiconducting target (4) extends in a plane (P) perpendicular to a main direction (Z) of the inductor element (3) along two dimensions (L1, L2), the internal and external radii (r1, r2) of the inductor element (3) being less than the dimensions (L1, L2) of the semiconducting target (4), or even in the order of half the dimensions (L1, L2) of the target (4).

FIG. 1

**FIG. 2**

FIG. 3

FIG. 4

EP 3 283 891 B1

FIG. 4A

FIG. 4B

**FIG. 5**

FIG. 6

FIG. 7

Coefficient de réflexion : partie réelle

Fréquence (MHz)

Conductivité (S/m)

EP 3 283 891 B1

FIG. 8

## RÉFÉRENCES CITÉES DANS LA DESCRIPTION

**Documents brevets cités dans la description**

- US 4286215 A

- US 4303885 A